# FASCICULE DE BREVET EUROPEEN

(11) **EP 4 308 370 B1**
(45) Date de publication et mention de la délivrance du brevet: **26.03.2025**
(21) Numéro de dépôt: 22706080.3
(22) Date de dépôt: 02.02.2022
(51) Int. Cl.: B29C 64/153, B29C 64/165, B60R 11/02, B60R 11/00, B60N 3/10, B33Y 10/00, B33Y 80/00

(54) **DISPOSITIF DE RÉCEPTION D'OBJET POUR VÉHICULE ET PROCÉDÉ DE FABRICATION D'UN TEL DISPOSITIF**
OBJEKTAUFNAHMEVORRICHTUNG FÜR EIN FAHRZEUG UND VERFAHREN ZUR HERSTELLUNG EINER SOLCHEN VORRICHTUNG
OBJECT-RECEIVING DEVICE FOR A VEHICLE AND METHOD FOR MANUFACTURING SUCH A DEVICE

(30) Priorité: 18.03.2021 FR 2102721
(43) Date de publication de la demande: 24.01.2024
(73) Titulaire: Stellantis Auto SAS, 78300 Poissy (FR)
(72) Inventeur: RAVASSARD, Stéphane, 91400 Gometz la Ville (FR); BELTRAN, Jérome, 92270 Bois Colombes (FR)
(74) Mandataire: BCIP
(86) Numéro de dépôt international: PCT/FR2022/050199
(87) Numéro de publication internationale: WO 2022/195184

(56) Documents cités:
- CN-U- 201 577 980
- DE-A1- 102010 062 875
- US-A- 5 052 649
- US-A1- 2002 185 578
- US-A1- 2005 236 545
- US-A1- 2007 230 099
- US-A1- 2018 208 094
- US-B2- 6 641 102

## Description

### Domaine technique

L'invention concerne un dispositif de réception d'objet pour véhicule et le procédé de fabrication d'un tel système. L'invention concerne également un accessoire pour véhicule prévu pour s'insérer dans un porte-gobelet du véhicule et recevoir un ou plusieurs objets. Plus généralement, l'invention concerne les dispositifs d'aménagement intérieur de véhicule, notamment automobile.

### Arrière-plan technologique

Les véhicules contemporains sont pour la plupart équipés d'un ou plusieurs logements de type porte-gobelet. Ce ou ces porte-gobelet sont par exemple prévus au niveau de la console centrale, sur le tableau de bord ou dans le panneau intérieur d'une portière.

Si la fonction première d'un porte-gobelet est de recevoir un gobelet ou une cannette, le porte-gobelet est souvent utilisé comme fourre-tout, par exemple pour recevoir des pièces de monnaie, un téléphone portable, des clés, etc.

Les dimensions d'un porte-gobelet étant fixes, seuls certains gobelets ou cannettes peuvent s'y loger correctement et être maintenus fixement par le porte-gobelet. En outre, les objets de petites tailles qui y sont déposés sont soumis au déplacement du véhicule et se déplacent à l'intérieur du porte-gobelet, ce qui est générateur de bruits ou de chute de ces objets. Il est également difficile de récupérer les petits objets tombés au fond d'un tel porte-gobelet.

L'utilisation qui est faite d'un porte-gobelet est donc particulièrement limitée.

Le document CN 201 577 980 U décrit un dispositif de réception d'objet correspondant au préambule de la revendication 1.

Les documents US2018/208094, US6732990 et US5052649 décrivent un dispositif de réception d'objet comportant une partie apte à s'engager dans un support de porte-gobelet de véhicule, et une partie supérieure configurer pour recevoir un objet. Par ailleurs, le document DE102010062875 décrit la fabrication de pièces pour automobile par fabrication additive.

### Résumé de l'invention

Un objet de la présente invention est d'améliorer les possibilités de rangement d'objets dans un véhicule.

Un autre objet de la présente invention est de diversifier l'utilisation faite des supports porte-gobelet dans un véhicule.

Selon un premier aspect, l'invention concerne un dispositif de réception d'objet pour véhicule, le dispositif étant obtenu par fabrication additive par fusion sur lit de poudre et étant formé d'un matériau flexible, le dispositif comprenant :
- une partie inférieure de forme adaptée pour s'engager en maintien au moins en partie dans un support porte-gobelet du véhicule ;
- une partie supérieure formée sur la partie inférieure, la partie supérieure étant configurée pour recevoir et maintenir au moins un objet.

La partie supérieure comprend un cadre entourant une partie centrale, le cadre ayant une rigidité supérieure à une rigidité de la partie centrale, la partie centrale étant configurée pour recevoir et maintenir le au moins un objet. La partie supérieure comprend un fond plein séparant la partie supérieure de la partie inférieure.

Selon une variante, le matériau flexible correspond à un polyuréthane thermoplastique. Selon une variante supplémentaire, la partie centrale comprend un ensemble de stries formées parallèlement les unes aux autres.

Selon encore une variante, la partie centrale comprend une pluralité de compartiments de dimensions et/ou de forme différentes.

Selon une variante additionnelle, la partie centrale possède une forme cylindrique de diamètre inférieur à un diamètre du support porte-gobelet.

Selon une variante supplémentaire, la partie centrale possède une structure maillée.

Selon un deuxième aspect, l'invention concerne un véhicule, par exemple de type automobile, comprenant un dispositif tel que décrit ci-dessus selon le premier aspect de l'invention.

### Brève description des figures

D'autres caractéristiques et avantages de l'invention ressortiront de la description des modes de réalisation non limitatifs de l'invention ci-après, en référence aux figures 1 à 5 annexées, sur lesquelles :
[Fig. 1] illustre schématiquement une partie d'un habitacle d'un véhicule, selon un exemple de réalisation particulier de la présente invention ;
[Fig. 2] illustre schématiquement un dispositif de réception d'objet embarqué dans l'habitacle de la figure 1, selon un premier exemple de réalisation particulier de la présente invention ;
[Fig. 3] illustre schématiquement un dispositif de réception d'objet embarqué dans l'habitacle de la figure 1, selon un deuxième exemple de réalisation particulier qui ne correspond pas à la présente invention ;
[Fig. 4] illustre schématiquement un dispositif de réception d'objet embarqué dans l'habitacle de la figure 1, selon un troisième exemple de réalisation particulier de la présente invention ;
[Fig. 5] illustre un organigramme des différentes étapes d'un procédé de fabrication du dispositif de réception d'objet selon l'une des figures 2 à 4, selon un exemple de réalisation particulier de la présente invention.

### Description des modes de réalisation

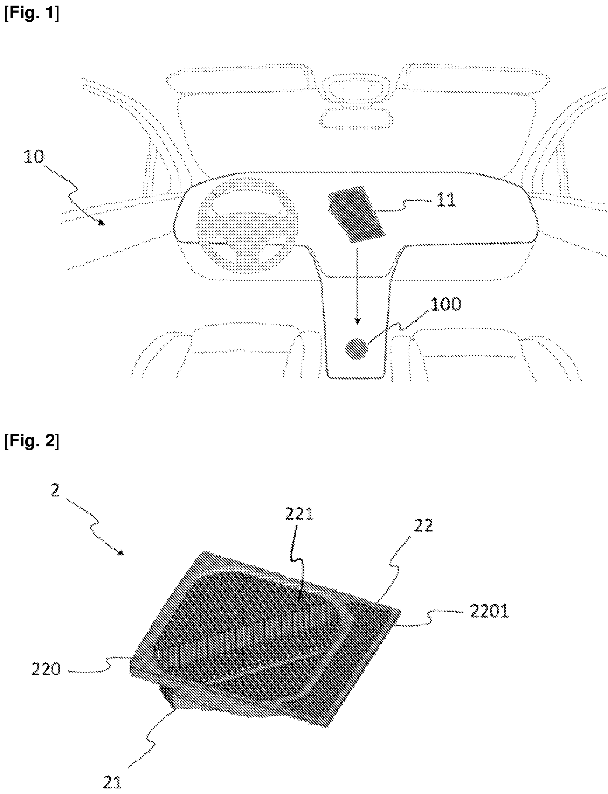

Un dispositif de réception d'objet pour véhicule et son procédé de fabrication de vont maintenant être décrits dans ce qui va suivre en référence conjointement aux figures 1à 5. Des mêmes éléments sont identifiés avec des mêmes signes de référence tout au long de la description qui va suivre.

[Fig. 1] illustre schématiquement une partie d'un habitacle d'un véhicule 10, selon un exemple de réalisation particulier et non limitatif de la présente invention.

La figure 1 présente une vue de l'intérieur d'un véhicule 10, notamment de la partie avant de l'habitacle du véhicule 10 comprenant notamment le volant et le tableau de bord du véhicule 10.

Le véhicule 10 correspond par exemple à un véhicule à moteur thermique, à moteur(s) électrique(s) ou encore un véhicule hybride avec un moteur thermique et un ou plusieurs moteurs électriques. Le véhicule 10 correspond ainsi par exemple à un véhicule terrestre, par exemple une automobile, un camion, un car.

Le véhicule 10 comprend un support porte-gobelet 100 (aussi appelé porte récipient) arrangé dans la console centrale du véhicule 10. Le support porte-gobelet 100 correspond par exemple à un puits formant un réceptacle agencé pour recevoir un gobelet (ou une cannette, une bouteille) introduit verticalement selon la flèche.

Selon un autre exemple, le véhicule 10 comprend 2 porte-gobelets disposés l'un à côté de l'autre dans la console centrale.

Selon une variante de réalisation, un ou plusieurs sont arrangés dans la planche de bord du véhicule, en complément ou à la place du ou des porte-gobelets de la console centrale. Bien entendu, la localisation de l'arrangement d'un tel support porte-gobelet n'est pas limitée aux exemples ci-dessus mais s'étend à toute localisation dans l'habitacle du véhicule 10.

Un dispositif de réception d'objet 11 est avantageusement embarqué dans le véhicule 10, ce dispositif de réception d'objet 11 étant configuré pour s'insérer dans le support porte-gobelet 100 dans un sens d'introduction vertical selon la flèche.

Le dispositif de réception d'objet 11 est par exemple fabriqué selon une méthode mettant en œuvre un frittage sélectif par laser, dite méthode SLS (de l'anglais « Selective Laser Sintering »). Un tel processus de fabrication permet de réaliser des objets 3D (tridimensionnels) en déposant des couches de poudre les unes sur les autres et les unes après les autres au fur et à mesure de la progression du processus, chaque couche étant soumise à un rayonnement laser qui permet de fritter ou fusionner la poudre selon un modèle 3D grâce à l'énergie du laser (comprise par exemple entre 200 et 400 W), tel qu'un laser CO₂ par exemple. Le dispositif de réception d'objet 11 est imprimé en une seule fois, c'est-à-dire en un seul ensemble, aucun assemblage des différentes parties formant le dispositif de réception d'objet 11 n'étant nécessaire à l'issus du processus d'impression. Le frittage sélectif par laser présente l'avantage de permettre l'impression de systèmes ou pièces à géométries complexes via la mise en œuvre par exemple de techniques de modélisation 3D telles que l'optimisation topologique. Un tel processus permet de réduire les coûts de fabrication et de montage du système de support 100.

Selon un autre exemple, le dispositif de réception d'objet 11 est obtenu ou fabriqué selon une méthode mettant en œuvre une fusion à jets multiples, dite méthode MJF (de l'anglais Multi Jet Fusion »), par exemple une méthode dite MJF HP, c'est-à-dire mise en œuvre par une machine de la société Hewlett-Packard^{®} à l'origine de la méthode MJF. Contrairement à la technique SLS, la poudre est menée jusqu'à son point de fusion dans la méthode MJF, en conservant le principe de dépôts de couches de poudre successives pour imprimer le dispositif 11 dans son ensemble en une seule fois, et non partie par partie. Par ailleurs, dans la méthode MJF, la fusion de la poudre est obtenue en utilisant un liant soumis à un rayonnement infra-rouge. Un liant liquide est par exemple pulvérisé (par exemple sous la forme de gouttelettes de 80 µm) sur un lit de poudre, qui se solidifie couche après couche pour former le système final en fin de processus. La méthode MJF, et plus particulièrement la méthode MJF HP, permet un gain de productivité important par rapport à la méthode SLS.

Le dispositif de réception d'objet 11 est avantageusement réalisé ou fabriqué dans un matériau flexible, par exemple un élastomère thermoplastique ou plus particulièrement un polyuréthane thermoplastique, dit TPU (de l'anglais « Thermoplastic Polyurethane »). Un TPU présente l'avantage d'allier les propriétés élastiques des élastomères et les propriétés mécaniques des plastiques. Un TPU possède notamment une très bonne résistance à l'abrasion et à l'usure.

Des exemples de tels dispositifs de réception d'objet 11 sont décrits avec plus de détail en regard des figures 2, 3 et 4.

[Fig. 2] illustre schématiquement un dispositif de réception de pièce 2, selon un premier exemple de réalisation particulier et non limitatif de la présente invention.

Le dispositif 2 est formée d'une partie inférieure 21 configurée pour s'encastrer dans le support porte-gobelet 100 et d'une partie supérieure 22 fermant l'ouverture supérieure du support porte-gobelet 100. La partie inférieure 21 et la partie supérieure 22 sont réalisées ou fabriquées par fabrication additive par fusion sur lit de poudre, en un seul ensemble.

La partie inférieure 21 est de forme adaptée pour s'engager en maintien dans le support porte-gobelet 100. La partie inférieure 21 a par exemple une section transversale circulaire, rectangulaire. Cette partie inférieure 21 est par exemple emmanchée ou manchonnée dans le support porte-gobelet, l'emmanchement ou le manchonnage étant facilité par la capacité de la partie inférieure à se déformer élastiquement pour épouser la forme du support porte-gobelet 100 lors de l'encastrement, le maintien du dispositif 2 dans le support porte-gobelet 100 étant obtenu par l'encastrement. La partie inférieure 21 s'enfonce par exemple sur une hauteur déterminée du support porte-gobelet, par exemple sur une hauteur égale à 2, 3, 4, 5 centimètres. Selon une variante, la partie inférieure a une hauteur égale à la profondeur du support porte-gobelet, ou légèrement inférieure, pour s'enfoncer sur toute la profondeur du support porte-gobelet.

Grâce aux propriétés élastiques du TPU, le dispositif 2 est aisément encastrable dans le support porte-gobelet 100 et peut aussi aisément être retiré du support porte-gobelet 100 à volonté, sans effort particulier d'un utilisateur. Le dispositif 2 correspond avantageusement à un dispositif amovible et repositionnable à volonté.

La partie inférieure 21 correspond avantageusement à un élément creux formé d'une enveloppe d'un à plusieurs millimètres d'épaisseur par exemple. Selon une variante, des renforts latéraux sont réalisés sur le contour intérieur de l'enveloppe lors de l'impression 3D du dispositif 2 pour assurer un meilleur maintien de la partie inférieure 21 dans le support porte-gobelet, ces renforts correspondant par exemple à des bandes de matière formant des surépaisseurs sur la hauteur du contour intérieur de l'enveloppe.

La partie supérieure 22 repose avantageusement sur la partie inférieure 21, la partie supérieure 22 correspondant à la partie visible du dispositif 2 lorsque ce dernier est emboité dans le support porte-gobelet 100.

La partie supérieure 22 est par exemple formé d'un cadre 220 entourant une partie centrale 221 de la partie supérieure 22. Le cadre 220 possède avantageusement une rigidité supérieure à celle de la partie centrale 221. Une rigidité plus élevée est par exemple obtenue avec une épaisseur pour le cadre 220 qui est supérieure à l'épaisseur de la partie centrale 221.

Le cadre 220 possède avantageusement une partie 2201 formée sur une extrémité du cadre 220 sur laquelle des motifs particuliers sont imprimés, en fonction par exemple du souhait de l'utilisateur (partie personnalisable). De tels motifs correspondent par exemple à du texte, un objet graphique tel qu'une icône ou un logo, ces motifs étant imprimés lors du processus de fabrication du dispositif 2 par impression 3D, dite aussi fabrication additive.

Selon une variante de réalisation, le cadre 220 est configuré pour reposer sur une surface formée autour du trou débouchant du support porte-gobelet 100, par exemple sur la surface de la console centrale selon l'exemple de la figure 1 autour du support porte-gobelet. Selon cette variante, la forme du cadre 220 est prévue pour épouser la surface sur laquelle il repose. Selon un autre exemple, le cadre a une forme essentiellement plane sur sa face inférieure (c'est-à-dire la face reposant sur la surface entourant le support porte-gobelet) pour s'adapter à un maximum de configurations et de véhicules.

La partie centrale 221 est configurée pour recevoir un ou plusieurs objets, par exemple un téléphone portable, des cartes de crédit, des pièces de monnaie ou tout autre objet. A cet effet et selon l'exemple particulier de la figure 2, la partie centrale 221 comprend un ensemble de stries (ou lamelles) formées parallèlement les unes aux autres, des pièces de monnaies pouvant par exemple s'insérer facilement dans ces stries. Selon une variante de réalisation, la surface supérieure de cette partie centrale correspondant à la face visible une fois le dispositif 2 encastré dans le support porte-gobelet est lisse et ne comporte pas de motif. Selon cette variante, une bonne accroche des pièces reçues par cette partie centrale 221 est obtenue grâce à la rugosité de la surface supérieure obtenue par la matière utilisée (par exemple TPU) et par le processus de fabrication additive.

La partie centrale 221 comprend un ou plusieurs compartiments, de mêmes dimensions, de même forme, ou au contraire de dimensions et/ou de formes différentes. Selon l'exemple particulier de la figure 2, la partie centrale 221 comprend plusieurs compartiments agencés à la manière d'un escalier, les différents compartiments ayant des profondeurs différentes.

Selon l'exemple de la figure 2, la partie centrale a une section rectangulaire, par exemple carrée. Selon un autre exemple, la partie centrale 221 a une section circulaire de diamètre inférieur au diamètre du support porte-gobelet 100, par exemple pour recevoir des gobelets, cannettes ou bouteilles de diamètres inférieurs au diamètre du support porte-gobelet 100.

La forme et la géométrie de la partie supérieure 220 varient avantageusement en fonction du ou des objets destinés à être reçus par cette partie supérieure. Une variété de formes et de géométries sont avantageusement obtenus grâce à la méthode de fabrication du dispositif 2, c'est-à-dire par fabrication additive par fusion sur lit de poudre.

Selon l'exemple de la figure 2, qui correspond à l'invention, la partie centrale 221 comprend un fond plein séparant cette partie centrale 221 de la partie inférieure 21, empêchant les objets reçus par la partie centrale 221 de tomber au fond de la partie inférieure 21.

Selon une variante de réalisation, le dispositif 2 est configuré pour n'occuper qu'une partie du volume offert par le support porte-gobelet 100. Selon cette variante, le dispositif correspond par exemple à la moitié du dispositif 2, par exemple selon la longueur ou la largeur du dispositif 2.

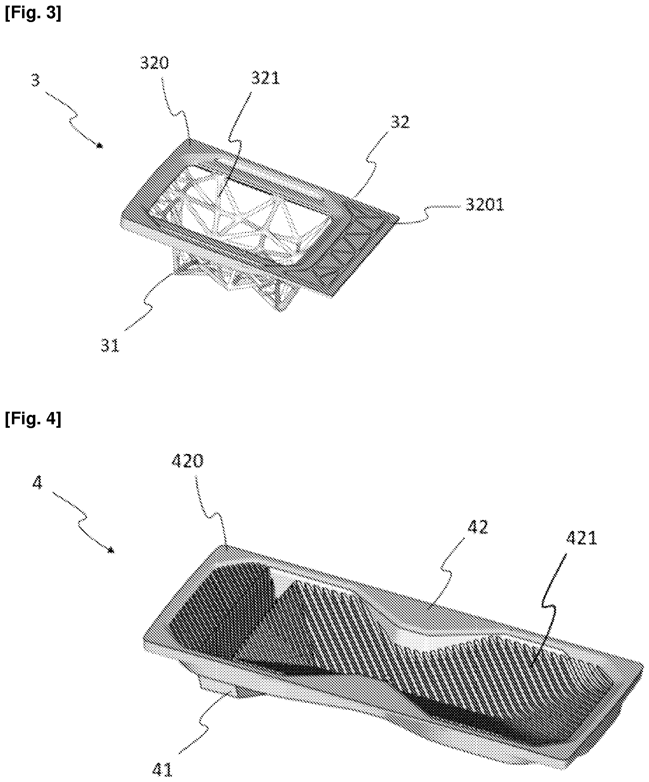

[Fig. 3] illustre schématiquement un dispositif de réception de pièce 3, selon un deuxième exemple de réalisation particulier qui ne correspond pas à la présente invention.

Comme le dispositif 2, le dispositif 3 de la figure 3 est formée d'une partie inférieure 31 configurée pour s'encastrer dans le support porte-gobelet 100 et d'une partie supérieure 32 formée sur la partie inférieure. La partie inférieure 31 et la partie supérieure 32 sont réalisées ou fabriquées par fabrication additive par fusion sur lit de poudre, en un seul ensemble.

Le dispositif 3 possède avantageusement au moins en partie une structure maillée. La partie inférieure 31 est par exemple formée d'un maillage comprenant une pluralité de mailles, chaque maille étant formée de brins du matériau utilisé pour fabriquer le dispositif 3.

La partie supérieure 32 comprend par exemple un cadre 320 formé d'une enveloppe de matière pleine, le cadre 320 entourant une partie centrale 321 formée d'une structure maillée. Le cadre possède avantageusement une rigidité supérieure à celle de la partie centrale 321 obtenue par le fait que le cadre 320 est formé d'une partie pleine alors que la partie centrale est ajourée du fait des mailles qui la composent.

Un tel dispositif 3 présente l'avantage de nécessiter moins de matière pour sa fabrication que le dispositif 2, le coût de fabrication du dispositif 3 étant ainsi inférieur au coût de fabrication du dispositif 2.

Le dispositif 3 n'est cependant pas adapté pour recevoir de petits objets tels que des pièces de monnaies qui passeraient entre les mailles et tomberaient dans le fond du support porte-gobelet 100. Un tel dispositif 3 est cependant adapté pour recevoir des objets plus volumineux tels qu'un téléphone portable, une paire de lunettes, etc.

[Fig. 4] illustre schématiquement un dispositif de réception de pièce 4, selon un troisième exemple de réalisation particulier et non limitatif de la présente invention.

Comme les dispositifs 2 et 3, le dispositif 4 de la figure 4 est formée d'une partie inférieure 41 configurée pour s'encastrer dans un ou deux supports porte-gobelet 100 et d'une partie supérieure 42 formée sur la partie inférieure. La partie inférieure 41 et la partie supérieure 42 sont réalisées ou fabriquées par fabrication additive par fusion sur lit de poudre, en un seul ensemble.

L'exemple de la figure 4 correspond à un dispositif de réception de pièce 4 configuré pour recouvrir deux supports porte-gobelet formés côte à côte. A cet effet, la partie inférieure 41 est configurée pour s'insérer dans un des deux supports porte-gobelet ou, selon un autre exemple de réalisation, la partie inférieure 41 comprend deux portions distinctes chacune prévue pour s'insérer par encastrement dans un support porte-gobelet.

Le dispositif 4 est également adapté pour venir recouvrir un unique support porte-gobelet, les dimensions du dispositif 4 étant supérieur à celles des dispositifs 2 et 3, notamment la dimension selon l'axe longitudinal du dispositif 4.

Selon l'exemple de la figure 4, la partie supérieure 42 comprend un cadre 420 entourant une partie centrale 421 comprenant un fond plein séparant cette partie centrale de la partie inférieure 41, la surface formant le fond étant pourvue de stries ou lamelles.

Bien entendu, la configuration de la dispositif 4 ne se limite pas à l'exemple illustré mais s'étend à toute configuration, par exemple une structure maillée comme pour le dispositif 3, avec un ou plusieurs compartiments comme pour le dispositif 2.

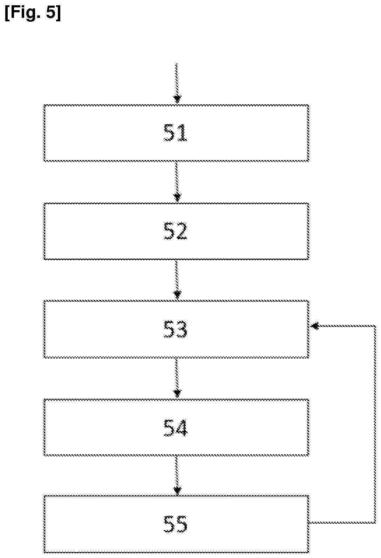

[Fig. 5] illustre un organigramme des différentes étapes d'un procédé de fabrication d'un dispositif de réception d'objet tel que le dispositif 2, 3 ou 4 décrit en regard des figures 2à 4, selon un exemple de réalisation particulier et non limitatif de la présente invention.

Le procédé est par exemple mis en œuvre par une imprimante 3D. Le procédé met avantageusement en œuvre une méthode dite de fabrication additive par fusion sur lit de poudre, par exemple une méthode dite SLS, MJF ou MJF HP.

Dans une première étape 51, des données représentatives d'un modèle tridimensionnel (3D) du dispositif de réception d'objet sont reçues. Ces données sont par exemple reçues d'un ordinateur relié à l'imprimante 3D via une liaison filaire (par exemple de type Ethernet ou USB) ou via une liaison sans fil (par exemple de type Wifi^{®}). Selon un autre exemple, ces données sont reçues d'un dispositif de stockage de données, de type clé USB introduit dans une interface de l'imprimante 3D prévue à cet effet.

Dans une deuxième étape 52, un lit de poudre est déposé sur une plaque support par un élément de l'imprimante 3D prévu à cet effet. La poudre correspond par exemple à du TPU.

Dans une troisième étape 53, le lit de poudre déposé dans la deuxième étape est balayé par un laser, le balayage étant contrôlé par une unité de contrôle de l'imprimante 3D en fonction d'instructions obtenues à partir des données reçues. Selon une variante de réalisation, lorsque la méthode d'impression mise en œuvre correspond à une méthode dite MJF ou MJF HP, un liant liquide est déposé sur le lit de poudre par une ou plusieurs buses d'une tête d'impression de l'imprimante 3D avant le balayage ou au fur et à mesure du balayage.

Dans une quatrième étape 54, la plaque support est abaissée d'une hauteur déterminée, par exemple une hauteur comprise entre 20 et 80 µm. Une telle hauteur correspond à la hauteur de chaque couche ou strate permettant d'obtenir le dispositif de réception d'objet.

Dans une cinquième étape 55, un nouveau lit de poudre (c'est-à-dire une nouvelle couche de poudre) est déposé sur la couche précédemment obtenue à l'étape 53.

Le procédé se poursuit en réitérant les étapes 53, 54 et 55 en finissant avec une étape de balayage 53 lorsque la dernière couche permettant d'obtenir le dispositif de réception de pièce par impression 3D a été déposée.

Selon une variante optionnelle, le procédé comprend en outre une ou plusieurs étapes de finition par traitement des surfaces externes du dispositif de réception d'objet.

Selon une autre variante optionnelle, le procédé comprend en outre une étape de peinture des surfaces externes du dispositif de réception d'objet en apposant une ou plusieurs couches de peinture.

Bien entendu, l'invention ne se limite pas aux modes de réalisation décrits ci-avant mais s'étend à un véhicule, par exemple automobile ou plus généralement un véhicule autonome à moteur terrestre, comprenant un ou plusieurs dispositifs de réception d'objet tels que le dispositif 2, 3 ou 4.

## Revendications

1. Dispositif de réception d'objet pour véhicule (10), ledit dispositif (11) étant obtenu par fabrication additive par fusion sur lit de poudre et étant formé d'un matériau flexible, ledit dispositif (11) comprenant :
- une partie inférieure (21) de forme adaptée pour s'engager en maintien au moins en partie dans un support porte-gobelet (100) dudit véhicule (10) ;
- une partie supérieure (22) formée sur ladite partie inférieure (21), ladite partie supérieure (22) étant configurée pour recevoir et maintenir au moins un objet, ladite partie supérieure (22) comprenant un cadre (220) entourant une partie centrale (221), ledit cadre (220) ayant une rigidité supérieure à une rigidité de ladite partie centrale (221), ladite partie centrale (221) étant configurée pour recevoir et maintenir ledit au moins un objet, **caractérisé en ce que** la partie supérieure comprend un fond plein séparant ladite partie supérieure (22) de ladite partie inférieure (21).

2. Dispositif selon la revendication 1, pour lequel ledit matériau flexible correspond à un polyuréthane thermoplastique.

3. Dispositif selon l'une des revendications précédentes, pour lequel ladite partie centrale (221) comprend un ensemble de stries formées parallèlement les unes aux autres.

4. Dispositif selon l'une des revendications précédentes, pour lequel ladite partie centrale (221) comprend une pluralité de compartiments de dimensions et/ou de forme différentes.

5. Dispositif selon l'une des revendications 1 ou 2, pour lequel ladite partie centrale possède une forme cylindrique de diamètre inférieur à un diamètre dudit support porte-gobelet.

6. Dispositif selon l'une des revendications 1 ou 2, pour lequel ladite partie centrale possède une structure maillée.

7. Véhicule (10) comprenant le dispositif de réception d'objet selon l'une des revendications précédentes.

## Patentansprüche

1. Vorrichtung (10) zum Aufnehmen von Fahrzeuggegenständen, wobei die Vorrichtung (11) durch additive Herstellung durch Schmelzen auf einem Pulverbett erhalten wird und aus einem flexiblen Material besteht, wobei die Vorrichtung (11) umfasst:
- ein Unterteil (21), das so geformt ist, dass es zumindest teilweise in einen Becherhalter (100) des Fahrzeugs (10) eingreift,
- ein Oberteil (22), das an dem Unterteil (21) ausgebildet ist, wobei das Oberteil (22) ausgebildet ist, um mindestens einen Gegenstand aufzunehmen und zu halten,
der obere Abschnitt (22) umfasst einen Rahmen (220), der einen zentralen Abschnitt (221) umgibt, wobei der Rahmen (220) eine Steifigkeit aufweist, die größer ist als eine Steifigkeit des zentralen Abschnitts (221), wobei der zentrale Abschnitt (221) konfiguriert ist, um den mindestens einen Gegenstand aufzunehmen und zu halten, **dadurch gekennzeichnet, dass** der obere Abschnitt einen festen Boden aufweist, der den oberen Abschnitt (22) von dem unteren Abschnitt (21) trennt.

2. Vorrichtung nach Anspruch 1, wobei das flexible Material ein thermoplastisches Polyurethan ist.

3. Vorrichtung nach einem der vorhergehenden Ansprüche, bei der der Mittelteil (221) eine Anordnung von parallel zueinander ausgebildeten Rillen aufweist.

4. Vorrichtung nach einem der vorhergehenden Ansprüche, bei der der zentrale Abschnitt (221) eine Vielzahl von Kammern unterschiedlicher Größe und/oder Form umfasst.

5. Vorrichtung nach einem der Ansprüche 1 oder 2, bei der der zentrale Abschnitt eine zylindrische Form mit einem Durchmesser aufweist, der kleiner als ein Durchmesser des Becherhalters ist.

6. Vorrichtung nach einem der Ansprüche 1 oder 2, bei der der Mittelteil eine Maschenstruktur aufweist.

7. Fahrzeug (10) mit der Objektaufnahmevorrichtung nach einem der vorhergehenden Ansprüche.

## Claims

1. A device (10) for receiving vehicle objects, said device (11) being obtained by additive production by melting on a powder bed and being made of a flexible material, said device (11) comprising:
- a base (21) shaped to engage at least partially in a cup holder (100) of the vehicle (10);
- an upper part (22) formed on the lower part (21), the upper part (22) being designed to receive and hold at least one object,
the upper portion (22) comprises a frame (220) surrounding a central portion (221), the frame (220) having a stiffness greater than a stiffness of the central portion (221), the central portion (221) being configured to receive and hold the at least one article, **characterized in that** the upper portion has a fixed bottom separating the upper portion (22) from the lower portion (21).

2. The device of claim 1, wherein the flexible material is a thermoplastic polyurethane.

3. A device according to any preceding claim, wherein the central portion (221) comprises an array of grooves formed parallel to each other.

4. An apparatus according to any one of the preceding claims, wherein the central portion (221) comprises a plurality of chambers of different sizes and/or shapes.

5. A device according to claim 1 or 2, wherein the central portion has a cylindrical shape having a diameter smaller than a diameter of the cup holder.

6. An apparatus according to claim 1 or 2, wherein the central portion comprises a mesh structure.

7. A vehicle (10) with the object pick-up device according to any one of the preceding claims.
